# EUROPEAN PATENT APPLICATION

(11) **EP 2 148 359 A2**
(43) Date of publication of application: **27.01.2010**
(21) Application number: 09251861.2
(22) Date of filing: 23.07.2009
(51) Int. Cl.: H01J 37/20, H01J 37/28, G01N 23/22

(54) **Specimen holder, specimen inspection apparatus, and specimen inspection method**

(30) Priority: 23.07.2008 JP 2008189574
(71) Applicant: JEOL Ltd., Akishima, Tokyo 196-8558 (JP)
(72) Inventor: Nishiyama, Hidetoshi, Tokyo 207-0022 (JP); Koizumi, Mitsuru, Tokyo 192-0031 (JP); Suga, Mitsuo, Saitama 343-0821 (JP)
(74) Representative: Cross, Rupert Edward Blount

(57) **Abstract**

Specimen holder (40), specimen inspection apparatus, and specimen inspection method are offered which can well observe or inspect a specimen (20) consisting of cultured cells. The specimen holder (40) has a body portion (37) and a film (32). The body portion (37) has a specimen-holding surface (37a) opened to permit access from the outside. The film (32) has a first surface (32a) forming the specimen-holding surface (37a). The specimen (20) disposed on the first surface (32a) of the film can be irradiated with a primary beam for observation or inspection of the specimen (20) via the film (32). A region coated with an electrically conductive film (301) is formed on the bottom surface (302) of the body portion (37) facing away from the specimen-holding surface (37a). An optically transparent region (302) not coated with the electrically conductive film (301) is also formed on the bottom surface (305). The specimen (20) can be well observed or inspected using an optical microscope by the use of the optically transparent region (302).

## Description

### BACKGROUND OF THE INVENTION

### 1. Field of the Invention

The present invention relates to specimen holder, specimen inspection apparatus, and specimen inspection method capable of well observing or inspecting a specimen consisting of cultured tissues or cells of an animal or plant.

### 2. Description of the Related Art

In the fields of life science and pharmaceutics, it has become important to observe reactions of biological cells produced by giving a stimulus (such as electricity, chemical substance, or medicine) to them. In the past, optical microscopes have been used for such observation. Manipulators or pipettes have been employed to give stimuli to cells. Frequently, important portions to be observed are very tiny regions of less than 0.1 µm that are impossible to observe with an optical microscope.

For example, diseases arising from inability to exchange substances normally among biological cells include hypertension, diabetesinsipidus,arrhythmia,myopathy,diabetes,and deprementia. Exchange of substances among cells is performed by ion channels having sizes of about 10 nm and existing in cell membranes. Because it is difficult to observe such ion channels with optical microscopes, there has been a demand for a technique enabling observation using a scanning electron microscope (SEM) having high resolution.

However, a specimen to be inspected with an inspection apparatus incorporating SEM capabilities is normally placed in a specimen chamber whose internal pressure has been reduced by vacuum pumping. The specimen placed in the specimen chamber, which in turn is placed in a reduced-pressure ambient in this way, is irradiated with an electron beam (charged particle beam). Secondary signals such as secondary electrons or backscattered electrons produced from the specimen in response to the irradiation are detected.

In such inspection of a specimen using SEM, the specimen is exposed to a reduced-pressure ambient. Therefore, moisture evaporates from the specimen, so that the cells die. It has been impossible to observe reactions of living cells to a stimulus.

When a specimen consisting of dead cells where the proteins have been fixed is placed in a vacuum, much labor and various pretreatments such as dehydration, drying, and metal vapor deposition that require a high degree of skillfulness have been necessary to prevent evaporation of moisture within a vacuum; otherwise, the specimen would be deformed. Accordingly, an exorbitantly long time has been required to observe the specimen. It has been impossible to achieve high throughput observations.

For these reasons, in order to observe a biological specimen, it is desired to prevent evaporation of moisture. When an inspection is performed under the condition where the specimen contains moisture, it is necessary to prevent the specimen from being exposed to the reduced-pressure ambient; otherwise, moisture would evaporate from the specimen. One conceivable method of inspecting a specimen using SEM without exposing the specimen to a reduced-pressure ambient in this way consists of preparing a specimen holder (sample capsule) whose opening (aperture) has been sealed off by a film, placing the specimen in the holder, and installing the holder in an SEM specimen chamber that is placed in the reduced-pressure ambient.

The inside of the specimen holder in which the specimen is placed is not evacuated. The film that covers the opening formed in the sample capsule can withstand the pressure difference between the reduced-pressure ambient inside the SEM specimen chamber and the ambient (e.g., atmospheric-pressure ambient) of the inside of the specimen holder that is not pumped down. Furthermore, the film permits an electron beam to pass therethrough (see patent document 1).

When a specimen is inspected, an electron beam is directed at the specimen placed within the sample capsule from outside the capsule via the film on the capsule that is placed in the SEM specimen chamber in a reduced-pressure ambient. Backscattered electrons are produced from the irradiated specimen. The backscattered electrons pass through the film on the capsule and are detected by a backscattered electron detector mounted in the SEM specimen chamber. Consequently, an SEM image is derived.

However, with this technique, the specimen is sealed in the closed space and so it has been impossible to give a stimulus to cells from the outside. Where the cells should be observed or inspected in vivo for a long time after the specimen consisting of the cells has been sealed in the sample capsule, there arises a problem.

Furthermore, an SEM image has high resolution but contains only black-and-whiteinformation. Therefore, it has been difficult to identify the observed tissue. On the other hand, in optical microscopy, fluorescence labeling technology has been established, and it is easy to identify tissues. If an SEM image and an optical microscope image derived from a substantially identical position can be observed substantially at the same time, the tissues can be identified with the high-resolution SEM image. However, with the aforementioned sample capsule, it is necessary to open the capsule for obtaining an optical microscope image. In order to derive an SEM image, it is necessary to close the capsule. Hence, it has been impossible to achieve the simultaneous observation.

Usually, cells are cultured by adsorbing them onto a laboratory dish having a diameter of more than 35 mm, pouring a culture medium onto the dish, and culturing the cells under conditions including a temperature of 36° to 38°C (normally, 37°C; in the case of insect cells, about 28°C) and a carbon dioxide concentration of 3 to 10% (normally, 5%). When the cells are observed, the cells are peeled off from the dish and put into the sample capsule.

However, the environment inside the sample capsule is different from the environment on the laboratory dish and so the possibility that cells survive within the specimen container is low. That is, with the sample capsule described in patent document 1, only about 15 µℓ of solution can be put into it. Because the environmental ambients including pH and osmotic pressure vary in a short time, it has been difficult to culture cells.

Examples of a method of acquiring an SEM image by irradiating a specimen with an electron beam via a film capable of withstanding the pressure difference between vacuum and atmospheric pressure in this way and detecting backscattered electrons emanating from the specimen are also described in non-patent document 1 (especially, Chapter 1: Introduction) and patent document 2.

Examples in which two films of the structure described above are placed opposite to each other with a specimen interposed between the films and in which an image is acquired by a transmission electron microscope are described in patent documents 3 and 4. Especially, patent document 3 also states a case in which an SEM image of the specimen interposed between such films is acquired.
[Patent document 1] JP-T-2004-515049
[Patent document 2] JP-A-51-42461
[Patent document 3] JP-A-47-24961
[Patent document 4] JP-A-6-318445
[Non-patent document 1] "Atmospheric scanning electron microscopy", Green, Evan Drake Harriman, Ph.D., Stanford University, 1993

A morphological variation caused by a reaction occurring in a cell after a stimulus is given to the cell using a manipulator or pipette takes place in a very tiny region within the cell and, therefore, the variation cannot be observed with an optical microscope. High resolution imaging using SEM is essential. In order to observe cells by SEM while maintaining the liquid, the specimen (cells) cultured on a laboratory dish is sealed into a sample capsule, and then the specimen is irradiated with an electron beam via a film formed on the capsule so as to image the specimen.

However, the sample capsule is a closed space. This makes it impossible to use a manipulator or pipette for giving a stimulus. Furthermore, the probability that cells sealed in sample capsules survive has been low. In addition, even if high resolution imaging is enabled by SEM, it is impossible to identify tissues. It is desired to observe the tissues with an optical microscope simultaneously because the optical microscope permits identification of the tissues.

In view of the foregoing, the present invention has been made. It would be desirable to provide specimen holder, specimen inspection apparatus, and specimen inspection method which permit a specimen as consisting of cultured cells to be observed or inspected well.

In this case, it would be further desired that biological cells can be cultured for a long time and thus a specimen can be well observed or inspected in vivo. Furthermore, it is desired that the specimen can be observed simultaneously with an optical microscope and an SEM in such a way that a stimulus can be given to the cultured cells using a manipulator or pipette and that the specimen under this condition can be well observed or inspected.

Where cells placed in a specimen container (specimen holder) where the cells can be cultured are observed or inspected by SEM, there is the possibility that the electron beam hits the specimen container. If so, the container is electrically charged, giving rise to a factor hindering observation and inspection of the specimen. Consequently, it is desired to prevent the charging by forming an electrically conductive film on portions of the specimen container that might be hit by the electron beam (especially, the bottom surface) such that electric charge escapes via the conductive film.

It is also desired that the specimen can be observed and inspected with an optical microscope even from the bottom side of the specimen holder. However, if the conductive film for preventing charging is formed on the bottom surface of the specimen container, and if the conductive film is made of a normal metal, it is difficult to observe the specimen such as cells in positions corresponding in position to the conductive film from the bottom side of the specimen container. In particular, where the conductive film is made of a normal metal, the conductive film blocks light. This makes it difficult to direct light at the specimen from the bottom surface of the specimen container on which the conductive film is formed to derive an optical image by means of the optical microscope.

### SUMMARY OF THE INVENTION

In view of the foregoing, the present invention has been made. It would be desirable to provide a specimen holder (specimen container) that is prevented from being charged if an electron beam hits the holder. The specimen holder makes it possible to observe or inspect the specimen well with an optical microscope by directing light at the specimen from the bottom surface of the specimen holder.

It would be further desirable of the invention to provide a specimen inspection apparatus and specimen inspection method using such a specimen holder.

A specimen holder according to one embodiment of the present invention has a body portion and a film. The body portion has a specimen-holding surface that is opened to permit access from the outside. The film has a first surface constituting the specimen-holding surface. A specimen disposed on the first surface of the film can be irradiated with a primary beam for observation or inspection of the specimen via the film. An electrically conductive region is formed on a second surface of the body portion that faces away from the specimen-holding surface. Also, a region that transmits light (i.e., an optically transparent region) is formed on the second surface.

Preferably, the conductive region is formed by coating with an electrically conductive film.

A specimen inspection apparatus according to an embodiment of the present invention is adapted to observe or inspect a specimen using any one of the above-described specimen holders, and has holder support means on which the specimen holder is placed, primary beam irradiation means for irradiating the specimen placed on the specimen-holding surface of the film of the specimen holder with a primary beam via the film, and signal detection means for detecting a secondary signal produced from the specimen in response to the beam irradiation.

A specimen inspection method according to one embodiment of the present invention consists of culturing a specimen on the specimen-holding surface of any one of the above-described specimen holders, irradiating the cultured specimen with a primary beam via the film, and detecting a secondary signal produced from the specimen in response to the irradiation by the beam.

In the present invention, the specimen cultured on the film located on the open specimen-holding surface can be irradiated via the film with the primary beam for observation or inspection of the specimen.

Consequently, the specimen as consisting of already cultured cells can be well observed or inspected in vivo or observed or inspected under liquid environments after the proteins have been fixed. Especially, if an electron beam is used as the primary beam, the specimen can be well observed or inspected by SEM.

Because the specimen-holding surface is open, access (contact or approach) to the specimen is enabled using a pipette or manipulator. A stimulus (e.g., spraying of a chemical substance or chemical stimulation) can be given to the specimen using a manipulator. The reaction can be observed or inspected. Additionally, the specimen can be observed with an optical microscope from the opposite side of the primary beam source. The same part of the specimen can be observed almost simultaneously with the SEM and optical microscope.

Especially, an electrically conductive region or a region covered with an electrically conductive film is formed on a second surface (bottom surface of the specimen holder) of the body portion of the specimen holder that faces away from the specimen-holding surface. An optically transparent region is also formed on the second surface.

Consequently, charging can be prevented if the electron beam hits the second surface facing away from the specimen-holding surface. Also, the specimen can be well observed or inspected with an optical microscope such as an inverted optical microscope (transmission optical microscope) by directing light at the specimen from the side of the second surface.

Other features and advantages of the present invention will become apparent from the following more detailed description, taken in conjunction with the accompanying drawings, which illustrate, by way of example, the principles of the invention.

### BRIEF DESCRIPTION OF THE DRAWINGS

Fig. 1 is a schematic block diagram of a specimen inspection apparatus according to the present invention;
Fig. 2 is a schematic block diagram similar to Fig. 1, but showing a different state;
Fig. 3 is a cross-sectional view of a specimen holder according to the invention, showing the structure of the holder;
Fig. 4 shows the bottom surface of the specimen holder shown in Fig. 3;
Fig. 5 shows perspective views of a framelike member constituting a specimen holder according to the invention, illustrating a method of fabricating the framelike member; and
Fig. 6 is a view illustrating the manner in which a specimen holder according to the invention is observed with an inverted optical microscope.

### DETAILED DESCRIPTION OF THE INVENTION

Specimen holder, specimen inspection apparatus, and specimen inspectionmethod according to the present invention are hereinafter described with reference to the drawings.

### Embodiment 1

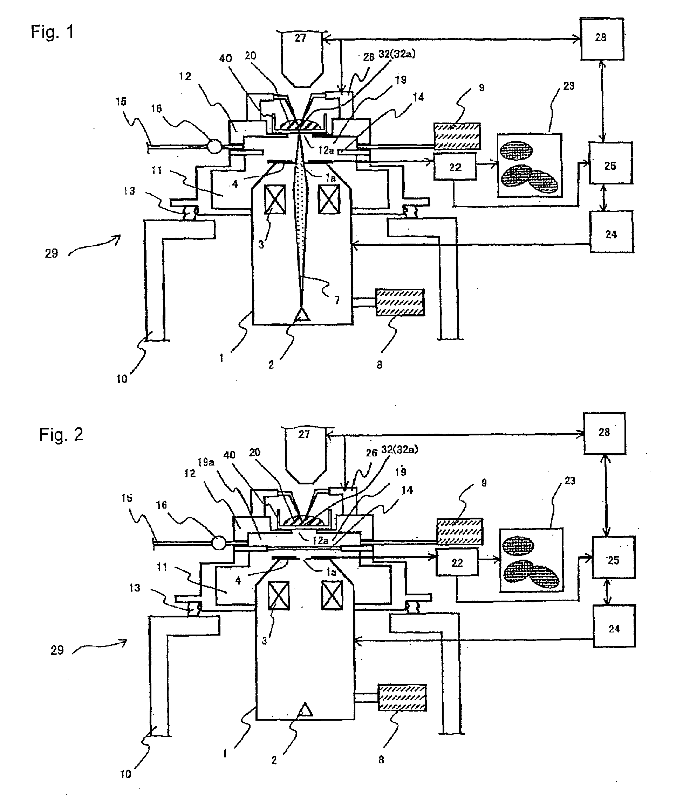

Fig. 1 is a schematic block diagram of a specimen inspection apparatus according to the present invention. The apparatus includes an electron optical column 1 forming primary beam irradiation means. An electron gun 2 forming an electron source is disposed in the electron optical column 1 and emits an accelerated electron beam (or, a charged particle beam) 7 that is a primary beam. The beam 7 is focused by a condenser lens (objective lens) 3.

The focused electron beam 7 is directed at a sample 20 via a specimen-holding film 32 (described later) formed on a specimen holder 40, the sample 20 being held on the holder 40. The sample 20 includes a specimen (biological cells in the present embodiment) and a liquid (a culture medium in the present embodiment).

During the irradiation, the electron beam 7 is deflected by deflection means (not shown). Thus, the beam 7 scans the sample 20. At this time, the specimen contained in the sample 20 is also scanned with the beam 7.

The front-end side of the electron optical column 1 is connected with a vacuum chamber 11. The electron gun 2 is mounted on the base side of the electron optical column 1, which in turn is located below the vacuum chamber 11. Because of this structure, the beam 7 released from the electron gun 2 travels upward through the column 1, passes through an opening 1a formed at the front end of the column 1, goes through the space in the vacuum chamber 11 and through the specimen-holding film 32, and reaches the sample 20.

The electron optical column 1 forms the primary beam irradiation means in this way. In the present embodiment, the column is of the inverted type. A backscattered electron detector 4 is mounted on the front-end side of the optical column 1 inside the vacuum chamber 11. The backscattered electron detector 4 detects backscattered electrons produced when the specimen included in the sample 20 is irradiated with the electron beam 7. For example, a semiconductor detector using a PN junction or a scintillator detector using a YAG crystal is used as the backscattered electron detector 4.

The inside of the electron optical column 1 is pumped down to a desired pressure by vacuum pumping means 8. The inside of the vacuum chamber 11 is evacuated to a desired pressure by vacuum pumping means (not shown). The vacuum chamber 11 is placed over a pedestal 10 via a vibration-proofing device 13.

A specimen holder support 12 is mounted on top of the vacuum chamber 11 and provided with a hole 12a to permit passage of the electron beam 7. The specimen holder 40 is placed on the holder support 12 via an O-ring (not shown). Consequently, the specimen holder 40 is withdrawably supported in the vacuum chamber 11.

An open-close valve 14 is mounted at a higher position in the vacuum chamber 11 to partition off a space 19 located between the specimen holder 40 and the front end of the electron optical column (primary beam irradiation means) 1 inside the vacuum chamber 11. Fig. 1 shows the state in which the open-close valve 14 is open. When the open-close valve 14 is closed, the space 19 in the vacuum chamber 11 is partitioned off as shown in Fig. 2. As a result, a hermetically closed space 19a is formed between the open-close valve 14 and the specimen-holding film 32. The space 19a is located on the side of the specimen holder 40 as viewed from the open-close valve 14.

Evacuation means (pressure-reducing means) 9 is mounted in communication with the space 19a and can evacuate the space 19a independently. A gas supply means (not shown) is connected with the space 19a. The gas supply means supplies a gas such as nitrogen or air into the space 19a to return the inside of the space 19a from reduced-pressure state to normal-pressure state (atmosphere). Consequently, the space 19a can return from reduced-pressure state to normal-pressure state independently.

Cleaning means (not shown) is connected with the space 19a. The cleaning means supplies a cleaning agent into the space 19a to clean the space 19a. As a consequence, the wall surface forming the space 19a is cleaned.

The cleaning agent used at this time is a cleaning liquid consisting of at least one of a detergent, ethanol, alcohol, acetone, and aqueous hydrogen peroxide. Alternatively, vapors of these materials may be used. The cleaning agent supplied in the space 19a is discharged from it through a discharge tube 15 after the cleaning of the space 19a. Another open-close valve 16 is mounted in the discharge tube 15. The open-close valve 16 is opened to permit the cleaning agent to be discharged to the outside through the discharge tube 15. When an inspection (described later) of the specimen is carried out, the valve 16 is closed.

The space 19a can be disinfected without using the cleaning agent by irradiating the space 19a with ultraviolet radiation or other radiation.

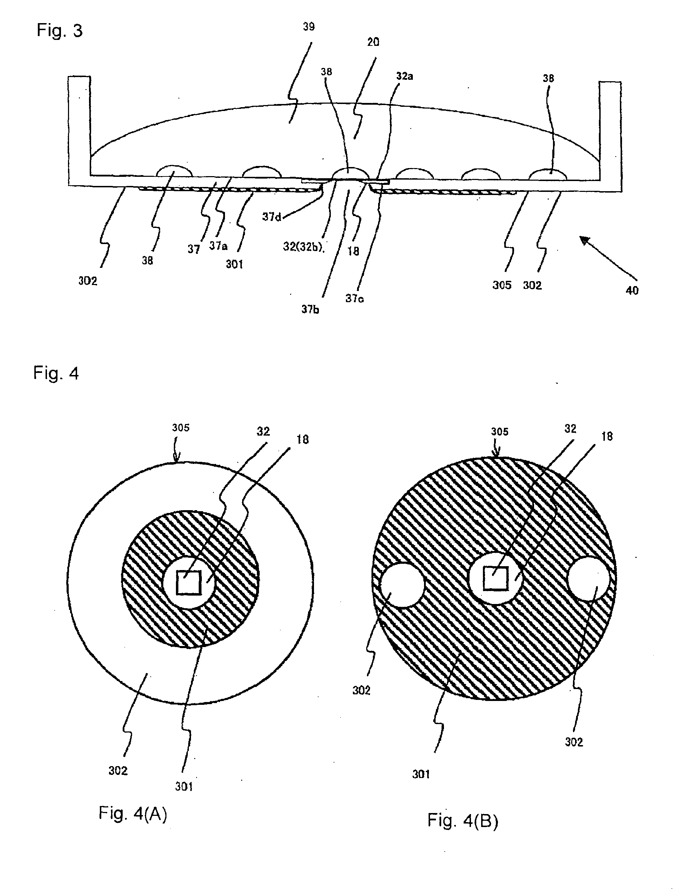

The specimen holder 40 is constructed as shown in Fig. 3. The specimen holder 40 is composed of a dish-like body portion 37 made of plastic or glass and a film holder (framelike member) 18 on which the specimen-holding film 32 is formed. The film 32 transmits the electron beam 7. A recessed portion is formed inside the body portion 37. The bottom surface of the recessed portion constitutes a specimen-holding surface 37a that is open.

A through-hole 37b is formed in a part (a central portion in the example of Fig. 3) of the specimen-holding surface 37a of the body portion 37. A step portion 37c is formed on the specimen-holding surface 37a and around the hole 37b. The film holder 18 is disposed on the step portion 37c and has the specimen-holding film 32. The specimen-holding film 32 has a first surface 32a constituting the specimen-holding surface 37a. The first surface 32a is substantially flush with the specimen-holding surface 37a of the body portion 37. Consequently, at least a part of the specimen-holding surface 37a of the specimen holder 40 is formed by the specimen-holding film 32.

A tapering portion 37d is formed around the hole 37b on the opposite side of the specimen-holding surface 37a. The tapering portion 37d tapers at an angle of 90° to 120° toward the specimen-holding surface 37a, i.e., spreads away from the specimen-holding surface 37a.

When the specimen holder 40 is placed on the holder support 12, the bottom surface 305 (the lower surface of the body portion 37 facing away from the specimen-holding surface 37a) is exposed to a vacuum ambient. A region of the bottom surface 305 that might be exposed to the electron beam 7 is covered with an electrically conductive film 301 to prevent charging of the region when the bottom surface 305 is irradiated with the beam 7. The film holder 18 is made of silicon and thus has electrical conductivity. Therefore, it is not necessary to coat the holder 18 with an electrically conductive film.

The conductive film 301 is in contact with the film holder 18. Electric charge accumulated by the irradiation by the electron beam 7 can be dissipated to the sample 20 via the film holder 18 made of silicon. Accumulation of electric charge can be prevented effectively by connecting a grounding line to the sample 20 or electrically connecting the conductive film 301 with the specimen holder support 12.

The conductive film 301 can be formed, for example, by vapor-depositing aluminum or gold or applying silver paste. The presence of the conductive film 301 can prevent or reduce charging of the specimen holder 40 when it is irradiated with the electron beam. Also, the presence can prevent displacement of the orbit of the beam 7, as well as distortion and illumination spots in the SEM image that would be normally produced by displacement of the orbit of backscattered electrons.

The bottom surface 305 of the specimen holder 40 has an exposed region 302 not covered with the conductive film 301. The exposed region 302 can be made to correspond to the portion brought into contact with the specimen holder support 12 when the specimen holder 40 is placed on the holder support 12.

The bottom surface 305 has the unexposed region on which the conductive film 301 is formed and the exposed region 302 on which the conductive film 301 is not formed. The bottom surface 305 can be separated into the unexposed and exposed regions as shown in Fig. 4(A) or Fig. 4(B). In the example shown in Fig. 4 (A), the unexposed region of the bottom surface 305 on which the conductive film 301 is formed preferably has an outside diameter set larger than the inside diameter of the hole 12a in the specimen holder support 12 to assure electrical contact between the conductive film 301 and the holder support 12 for preventing charging of the specimen holder 40.

In the example shown in Fig. 4(B), the bottom surface 305 of the specimen holder 40 is nearly totally covered with the conductive film 301 except for two regions 302 not covered with the conductive film 301. In the examples of Figs. 4(A) and 4(B), the exposed regions 302 are used to observe a specimen 38 on the specimen holder 40 using an inverted optical microscope that is one kind of normal transmission optical microscope.

If the conductive film 301 is made of a material that is transparent to visible light and exhibits electrical conductivity such as indium tin oxide (ITO), zinc oxide, or tin oxide, then it is only necessary that the conductive film 301 be formed substantially over the whole bottom surface 305 of the specimen holder 40. That is, in this case, the bottom surface 305 does not need to have the region 302 not covered with the conductive film 301 because the material of the conductive film 301 does not block light and because light for observation can be directed at the specimen 38 through the conductive film made of this material. In this case, it is not necessary to form the unexposed regions 302. Consequently, the conductive film 301 does not need to be patterned. Hence, the specimen holder 40 of the present invention can be fabricated efficiently.

Furthermore, if the body portion 37 itself forming the specimen holder 40 is made of a material that is transparent to visible light and shows electrical conductivity as described above, it is not necessary to form the conductive film 301.

In the above-described structure, the conductive film 301 has a resistivity of less than 10⁴ Ω · m. Furthermore, where the body portion 37 is made of a material that is transparent to visible light and shows electrical conductivity, satisfactory results are obtained if the resistivity of the material is less than 10⁴ Ω · m. Consequently, during the irradiation by the electron beam, charging of the specimen holder 40 can be prevented sufficiently.

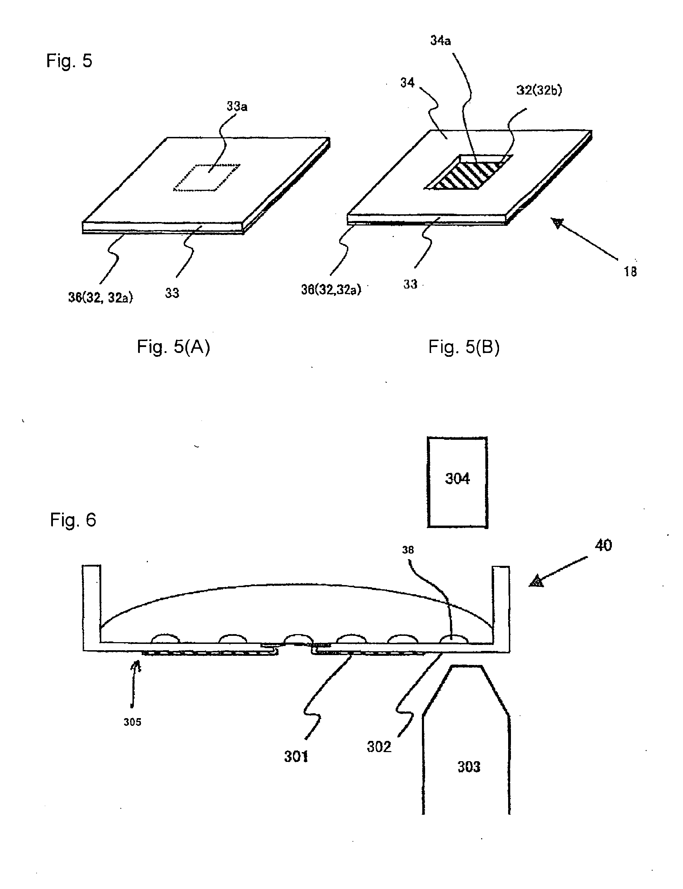

The specimen-holding film 32 is formed on the film holder 18 as shown in Fig. 5(B). The first surface 32a of the specimen-holding film 32 (lower surface as viewed in Fig. 5(B); upper surface as viewed in Fig. 3) is exposed. The sample 20 containing liquid such as a culture medium and a specimen (cells) is placed on the first surface (specimen-holding surface) 32a of the specimen-holding film 32. Since the first surface 32a is under atmospheric pressure, evaporation of moisture from the sample 20 can be suppressed to a minimum.

The film holder 18 has a substrate portion 34 formed on the second surface 32b (upper surface in Fig. 5(B); lower surface in Fig. 3) of the specimen-holding film 32. The substrate portion 34 is centrally provided with an opening 34a covered with the specimen-holding film 32. A central portion of the second surface 32b of the specimen-holding film 32 is exposed to the inside ambient of the vacuum chamber 11 through the opening 34a.

A method of creating the film holder 18 is next described. First, as shown Fig. 5(A), a substrate having a silicon layer 33 forming the substrate portion 34 and a silicon nitride film 36 formed on one surface (lower surface in Fig. 5(A)) of the silicon layer 33 is prepared. The silicon nitride film 36 is formed on the silicon layer 33 (substrate portion 34) by a CVD (chemical vapor deposition) technique such as plasma CVD. The first surface (lower surface in Fig. 5(A)) of the silicon nitride film 36 is exposed, while the second surface of the silicon nitride film 36 is covered with the silicon layer 33. The silicon nitride film 36 forms the specimen-holding film 32 of the film holder 18.

Then, a central portion 33a of the other (upper) surface of the silicon layer 33 in Fig. 5(A) is selectively etched. The opening 34a is formed in the central portion 33a of the silicon layer 33 as shown in Fig. 5(B). Consequently, a part of the second surface of the silicon nitride film 36 is exposed by the opening 34a, which in turn is covered with the silicon nitride film 36. The silicon nitride film 36 forms the specimen-holding film 32 of the film holder 18. The second surface of the silicon nitride film 36 corresponds to the second surface 32b of the specimen-holding film 32. As a result, the film holder 18 made of the framelike member having the opening 34a is created.

The film holder 18 created in this way is turned upside down from the state of Fig. 5(B). The first surface of the silicon nitride film 36 that is the specimen-holding film 32 is taken as an upper surface. The first surface being the upper surface of the silicon nitride film 36 becomes the first surface 32a of the specimen-holding film 32 of the film holder 18. It is also possible to take the second surface 32b as the upper surface. In Fig. 4, the contour of the film holder 18 is square. According to the need, the film holder may be shaped circularly.

The film holder 18 is firmly held to the step portion 37c around the hole 37b formed in the body portion 37 forming the specimen holder 40. Thus, the specimen holder 40 is created. To attach the holder 18 to the step portion firmly, bonding using a silicone-based or epoxy-based adhesive or fusion making use of heat, ultrasonic waves, or laser light can be used. As a result, the film holder 18 is firmly held in a position corresponding to the hole 37b in the specimen-holding surface 37a of the body portion 37.

In the present embodiment, the body portion 37 and film holder 18 are combined to fabricate the specimen holder 40. The specimen-holding film may be directly firmly bonded to the body portion 37. The body portion 37 and specimen-holding surface may be formed integrally. Furthermore, cell adhesion molecules (described later) acting as molecules for adhering the specimen may be applied to at least the specimen-holding surface 37a including the first surface 32a of the specimen-holding film 32.

The thickness of the silicon nitride film 36 is set to a range of from 10 to 1,000 nm. The specimen-holding film 32 of the film holder 18 is made of silicon nitride. In addition, the film 32 may be made of silicon oxide, boron nitride, polymer, polyethylene, polyimide, polypropylene, or carbon. Where films of these materials are used, their film thicknesses are set to a range of from 10 to 1,000 nm. The specimen-holding film 32 made of the aforementioned material transmits the electron beam 7 but does not transmit gas or liquid. Moreover, it is necessary that the film be capable of withstanding a pressure difference of at least 1 atmosphere across the opposite surfaces. As the thickness ofthespecimen-holdingfilm32 is reduced, scattering of the electron beam 7 is reduced and, therefore, the resolution is improved but the film is more easily damaged. As the thickness is increased, scattering of the electron beam 7 increases, resulting in decreased resolution. However, the film is less likely to be damaged. The preferable thickness of the film is 20 to 200 nm.

Referring back to Fig. 1, the structure of the specimen inspection apparatus is described in further detail. A detection signal produced from the backscattered electron detector 4 is fed to an image formation device 22 disposed outside the vacuum chamber 11. The image formation device 22 forms image data based on the detection signal. The image data corresponds to an SEM image.

The image data is sent to a display device 23. An image based on the image data sent in is displayed on the display device 23. The displayed image is an SEM image. Image data created by the image formation device 22 is sent to a computer 25 according to the need. The computer 25 performs image processing on the image data and carries out a decision based on the result of the image processing.

An electron beam apparatus portion 29 equipped with the electron optical column 1 and the vacuum chamber 11 is controlled by an electron beam controller 24. The apparatus portion 29 is located under the specimen holder 40. A manipulator 26 for giving a stimulus (such as a voltage, chemical substance, or medicine) to the specimen and for moving the specimen if necessary and an optical microscope 27 are placed on the specimen holder support 12. The microscope 27 permits one to observe the specimen and to check the position of the manipulator 26. These components are controlled by an overall controller 28.

The optical axis of the optical microscope 27 is coincident with the optical axis of the electron beam 7. Alternatively, the center of field of view of the optical microscope 27 is coincident with the center of field of view of the SEM image. A region observed by the optical microscope can be made substantially coincident with the SEM image. The field of view of the SEM image and the field of view of the optical microscope 27 can be adjusted by manipulating the manipulator 26 or moving the specimen holder support 12 on which the specimen holder 40 is installed by means of a moving mechanism (not shown).

The specimen inspection apparatus according to the present invention has the electron beam apparatus portion 29, manipulator 26, optical microscope 27, electron beam controller 24, overall controller 28, image formation device 22, and display device 23. These portions are connected with the computer 25. Information can be exchanged between these portions.

An inspection method according to the present invention is next described. First, as shown in Fig. 3, cells 38 becoming a specimen are cultured within a culture medium 39 using the specimen holder 40. In order to culture the cells 38 as shown in Fig. 3, it is necessary to graft the cells from the laboratory dish where they have been previously cultured to the specimen holder 40. For this purpose, a normal method as described below is used.

First, the culture medium is discarded from the laboratory dish where the cells have been previously cultured. A mixture liquid of trypsin and EDTA (ethylenediaminetetraacetic acid) is put into the dish to peel off the cells adsorbed to the dish. The peeled cells are then recovered into a centrifuge tube. A culture medium is put into the tube. The trypsin is inactivated and then the cells are spun down. Then, the supernatant fluid is discarded from the centrifuge tube. More culture medium is added, and the liquid is stirred. A part (e.g., 1/10) of the stirred liquid including the cells 38 is entered into the specimen holder 40. More culture medium 39 is added according to the need. Under this condition, the holder is allowed to stand still in a cell culture chamber. After a lapse of several hours, the cells 38 begin to be adsorbed onto the specimen-holding surface 37a of the specimen holder 40 including the surface 32a of the specimen-holding film 32 and proliferate.

An inverted optical microscope is used to observe the state of the cultivation as shown in Fig. 6. The microscope has an obj ective lens 303 and a light source 304 which are disposed on opposite sides of the specimen holder 40. To observe the manner in which the cells are cultured, it is necessary to observe a large number of cells. The specimen-holding film 32 of the specimen holder 40 has a thickness of 10 to 100 nm, for example, and so light can be transmitted through the film. Cells in the regions canbe checked. However, in order to withstand the differential pressure of 1 atm., the area of the specimen-holding surface is restricted to 0.5 mm × 0.5 mm, for example. For this reason, it is impossible to check the state of many cells in that region. The region 302 of the bottom surface 305 of the specimen holder 40 is transparent and so a large number of cells can be observed easily with the inverted optical microscope. The present work can be performed at an efficiency substantially equivalent to the efficiency of a method in which cells cultured in a commercially available laboratory dish are observed. Consequently, an operator who is accustomed to the prior-art method does not suffer from stress.

As a result, the cells 38 becoming a specimen to be inspected or observed are cultured within the specimen holder 40. It follows that the sample 20 containing the cultured cells 38 and culture solution 39 is constituted. Depending on biological cells, if cell adhesion molecules (molecules for adhesion of the specimen) are applied to the specimen-holding surface 37a of the specimen holder 40 (especially, the first surface (specimen-holding surface) 32a of the specimen-holding film 32 that is a region observed with an electron beam), cultivation is facilitated. The cell adhesion molecules cause cells arranged for cultivation and cells proliferated by cultivation to be adsorbed onto the specimen-holding surface. Examples of the cell adhesion molecules include collagen, fibronectin, vitronetin, cadherin, integrin, claudins, desmogleins, neuroligin, neurexin, selectin, laminins, and poly-L-lysine. By causing the cells to adhere to the specimen-holding film 32 via the cell adhesion molecules as described above, deterioration of the resolution due to scattering of the electron beam 7 can be reduced to a minimum when the cells are irradiated with the beam 7 via the specimen-holding film 32.

After the cells becoming a specimen are cultured within the specimen holder 40 as described above, the specimen holder 40 is placed on the holder support 12. At this time, the open-close valve 14 is closed and in the state of Fig. 2. The space 19a sealed between the valve 14 and the specimen-holding film 32 is at a normal pressure, or in an atmospheric-pressure ambient. Within the vacuum chamber 11, the space located under the valve 14 is in a given vacuum state (reduced-pressure state).

The inside of the electron optical column 1 in communication with this space is evacuated to a desired vacuum state by the vacuum pumping means 8. The pressure (degree of vacuum) inside the vacuum chamber 11 is set to about 10⁻³ to 10⁻⁴ Pa, for example. The pressure (degree of vacuum) inside the electron optical column 1 (especially, around the electron gun 2) is set to about 10⁻⁴ to 10⁻⁵ Pa, for example.

Under this condition, the space 19a is reduced in pressure down to a vacuum using the evacuation means 9. At this time, to prevent the specimen-holding film 32 from being damaged due to rapid pressure variations from the atmospheric-pressure state, the pressure is reduced from 1 atm. (101325 Pa) that is the atmospheric pressure down to about 1/2 to 1/10 atm. (50 kPa to 10 kPa), using a needle valve (not shown), in a time from 1 second to 100 seconds. During this process step, it is checked that the specimen-holding film 32 of the specimen holder 40 is not destroyed.

After checking that the specimen-holding film 32 has not been destroyed by the above-described step, the positions of the cells (specimen) 38 and of the manipulator 26 are checked with the optical microscope 27. Microelectrodes and a glass microtube are installed at the front end of the manipulator. A voltage can be applied to the cells through the microelectrodes. A liquid can be made to flow in and out through the glass microtube.

Under this condition, the manipulator 26 is moved while making an observation with the optical microscope 27 to bring the cells 38 close to the glass microtube. Then, a negative pressure is applied to the glass microtube to bring it into intimate contact with the cell membranes. As a result, potential response can be measured.

When the manipulator 26 is moved as described above, if the specimen-holding film 32 is erroneously damaged, contamination due to diffusion of the sample 20 is restricted to within the space 19a because the open-close valve 14 is closed. If the specimen-holding film 32 should be destroyed and the inside of the space 19a be contaminated due to diffusion of the sample 20, cleaning of the space 19a is possible as described previously.

The liquid detergent or vapor used for the cleaning can be discharged and discarded via the discharge tube 15 by opening the open-close valve 16. It is possible to make the space 19a less susceptible to contamination by coating the wall surface forming the space 19a with boron nitride or fluororesin.

When the space 19a is in a reduced-pressure state or a vacuum state, it is checked that the specimen-holding film 32 on which the sample 20 is placed is not destroyed. Then, the open-close valve 14 is opened. Thus, the space inside the vacuum chamber 11 is ceased to be partitioned to place the lower space in the vacuum chamber 11 into communication with the space 19a. Thereafter, in order to prevent light from entering the backscattered electron detector 4 via the specimen-holding film 32, the light irradiation of the optical microscope 27 is ceased. Other extraneous light is blocked in a manner not shown. The blocking also shields the film holder 18 and sample 20 against radiation rays produced when the electron beam 7 hits the film holder 18 and sample 20.

Then, as shown in Fig. 1, the electron beam 7 is directed at the sample 20 including the cells 38 from the electron optical column 1 to perform imaging. The beam 7 passes through the specimen-holding film 32 of the specimen holder 40 and hits the cells 38. Backscattered electrons produced from the cells 38 in response to the irradiation are detected by the backscattered electron detector 4.

Since the aforementioned tapering portion 37d is formed in the hole 37b of the body portion 37 forming the specimen holder 40, collision of the backscattered electrons against the inner side surface of the tapering portion 37d can be suppressed to a minimum. That is, the backscattered electrons can be suppressed from being blocked. The backscattered electrons can be detected efficiently by the backscattered electron detector 4.

A detection signal produced from the backscattered electron detector 4 is fed to the image formation device 22, which in turn forms image data based on the detection signal. Based on the image data, an image (SEM image) is displayed on the display device 23.

Subsequently, an electrical stimulus is given to the cells 38 using the microelectrodes installed at the front end of the manipulator 26. An SEM image is acquired in the same way as in the above-described process step. The response of the cells 38 to the stimulus is checked.

After the imaging, the open-close valve 14 is closed to prevent contamination of the electron optical column 1 if the specimen-holding film 32 should be destroyed. Before a variation caused by application of a stimulus to the cells 38 is observed by SEM as described above, an observation may be made with the optical microscope 27. Also, at this time, if the open-close valve 14 is closed, risk of contamination occurring when the specimen-holding film 32 is broken can be reduced. In any case, if the open-close valve 14 is closed when the electron beam 7 is not directed at the sample 20, the probability of contamination of the inside of the apparatus can be reduced by shortening the interval forwhichthe open-closevalve 14 is opened during inspection.

Where the speed of reaction of the cells 38 to the stimulus is low, the open-close valve 14 may be once closed. The valve 14 may be again opened at a time when a reaction is deemed to have taken place. Then, imaging may be performed using the electron beam 7. The reaction can be checked with the optical microscope 27.

The manipulator 26 can have a mechanism capable of spraying a chemical substance or medicine into the sample 20. Behavior of the cells 38 in response to the chemical substance or medicine can be observed or inspected while observing the cells by SEM.

Furthermore, a function of permitting a liquid to flow out can be imparted to the manipulator 26. This permits the sprayed substance to be recovered. Also, the pH of the culture medium and the osmotic pressure can be maintained constant.

In the foregoing, backscattered electrons are used to form an image. Backscattered electrons produce a signal intensity proportional to the atomic number. Therefore, where the specimen is almost totally made of substances of low atomic numbers such as a biological specimen, the image contrast is very low, and it is difficult to improve the resolution. Accordingly, a heavy metal such as gold may be adsorbed onto portions of the cells 38 to be noticed in their behavior. In particular, gold is adsorbed onto the portions (antigen) via an antibody by causing the antigen tagged with gold particles having the nature of being adsorbed on the portions (antigen) to be sprayed over the cells by making use of an antigen-antibody reaction. Furthermore, a fluorescent dye or quantum dots (e. g. , nanoparticles of Si or particles of CdSe coated with ZnS and having sizes of 10 to 20 nm) that emit light when irradiated with an electron beam may be previously adsorbed onto certain portions of the cells 38, and the emitted light may be observed with an optical microscope.

In the above embodiment, normally used gold particles have particle diameters of 10 to 30 nm. However, the adsorptive force between the antibody and gold particles is weak, and gold particles of 10 to 30 nm may not be attached. In this case, very small gold particles (nanogold particles) having particle diameters of the order of nanometers are first attached to the antibody. Under this condition, the gold particles are too small and it is difficult to observe them by SEM. Silver is adsorbed around the gold particles by making use of a silver sensitizer. This makes it easier to detect them by SEM.

### Embodiment 2

An example is described in which the same portion of a specimen is observed almost simultaneously with an optical microscope and an SEM. Biological cells are cultured with the specimen holder 40 by the method described in embodiment 1 as shown in Fig. 3. Then, the cells are fixed using glutaraldehyde or formaldehyde.

Furthermore, the cells are stained to facilitate observation with the optical microscope and SEM. First, the tissues of the cells are stained separately for optical microscopy. For example, in order to stain cellules, the SelectFX Alexa Fluor 488 Endoplasmic Reticulum Labeling Kit (S34253) available from Invitrogen Corporation may be used. Subsequently, phosphotungstic acid or platinum blue staining is used for SEM to increase the efficiency at which backscattered electrons are released.

After completing the pretreatment in this way, the specimen holder 40 is placed on the specimen holder support 12 as shown in Fig. 1 and an observation is made in the same way as in embodiment 1. Because the upper side of the specimen holder 40 is open, it is possible to make an observation with the optical microscope 27 while making an SEM observation. Furthermore, optical microscope and SEM observations of the same portion of a specimen can be made almost simultaneously because the optical axis of the optical microscope 27 is coincident with the optical axis of the electron optical column 1. Consequently, the position of the tissues of interest (e.g., cellules) can be identified with the optical microscope, and a high-resolution SEM image can be obtained.

In the foregoing embodiment, cells previously cultured in a laboratory dish are taken out and grafted onto the specimen holder 40, where the cells are cultured. Alternatively, cells may be taken as another specimen from a living organism, directly placed on the specimen-holding surface 32a of the specimen holder 40, and cultured.

In the embodiment described so far, the open specimen holder 40 is used and so reactions of cells to a stimulus can be imaged and inspected in vivo at high resolution by SEM, which has been heretofore impossible to achieve. Furthermore, the specimen holder is made usable that enables inspection of cells by the specimen inspection apparatus while the cells are being cultured. In addition, the same portions of cells can be observed substantially simultaneously with an optical microscope and an SEM, whether the cells are dead or alive. A high-resolution image can be derived by SEM. The tissues of the cells can be stained separately with the optical microscope. The tissues in the high-resolution image can be identified. Additionally, observations under liquid environments are possible. This dispenses with the prior-art steps for observations under vacuum environments including dehydration, drying, and metal vapor deposition. The pretreatment can be carried out at higher speed. High throughput observations can be achieved.

The cells referred to in the above embodiments are various tissue cells including nerve cells, adrenal cortical cells, cardiac muscle cells, gastric cells, intestinal cells, and vascular cells.

In the above embodiments, backscattered electrons are used as a secondary signal. Information about the specimen 38 consisting of cells can also be obtained by detecting secondary electrons, X-rays, or cathodoluminescent light produced when the specimen 38 is irradiated with the electron beam 7 or electric current absorbed into the specimen 38. It is convenient to use the manipulator 26 in measuring the absorption current.

It is required that the specimen-holding film 32 of the present embodiment withstand a pressure difference of at least 1 atm. and that gas or liquid do not flow in or out. Specifically, the material of the film 32 includes at least one of polymer, polyethylene, polyimide, polypropylene, carbon, silicon oxide, silicon nitride, and boron nitride.

In the above embodiments, an electron beam is used as the primary beam. If the specimen-holding film 32 shows sufficient shock resistance and strength against impingement of other charged particle beam such as a helium ion beam, the invention can also be applied in a case where the other charged particle beam is used. In addition, an inverted SEM is used in the above embodiments of the present invention. Depending on the specimen, a normal, non-inverted SEM may be used without problem.

In this way, the specimen holder of the present invention has the body portion 37 and the film 32. The body portion 37 has the specimen-holding surface 37a opened to permit access from the outside. The first surface 32a of the film 32 constitutes the specimen-holding surface. The specimen 38 disposed on the first surface 32a of the film 32 can be irradiated via the film 32 with the primary beam 7 for observation or inspection of the specimen. The electrically conductive region (covered with the electrically conductive film 301) is formed on the second surface (bottom surface 305) of the body portion 37 facing away from the specimen-holding surface 37a. Furthermore, the optically transparent region 302 is formed on the second surface. The optically transparent region 302 is not covered with the conductive film 301.

The primary beam for observation or inspection of the specimen can be directed at the specimen 38 via the film 32 from a side of the second surface 32b of the film 32 which is in contact with the vacuum ambient and which is on the opposite side of the first surface 32a of the film 32. The specimen 38 is disposed on the first surface 32a of the film 32 in contact with an open ambient.

The hole 37b is formed in a part of the specimen-holding surface 37a of the body portion 37. The film 32 is disposed to cover the hole 37b. The film 32 is formed on the framelike member 18 so as to cover the opening in the framelike member 18. The framelike member 18 is disposed in a corresponding manner to the hole 37b in the body portion 37. The framelike member 18 is disposed on the step portion 37c formed around the hole 37b in the body portion 37. The framelike member 18 and body portion 37 are firmly coupled together by bonding using an adhesive or by fusion using heat, ultrasonic waves, or laser light.

The electrically conductive region or the electrically conductive film 301 can be made of at least one of gold, silver, aluminum, indium tin oxide, zinc oxide, and tin oxide. The electrically conductive region or the electrically conductive film 301 has a resistivity of less than 10⁴ Ω · m.

The body portion 37 can be made of at least one of plastic, glass, indium tin oxide, zinc oxide, and tin oxide. The body portion 37 is shaped like a dish. The bottom surface of the recessed portion in the dish-like body portion forms the specimen-holding surface 37a. The volume of the portion of the specimen holder 40 that can hold the sample containing the specimen 38 is more than 1 mℓ.

The thickness of the film 32 can be set to between 10 nm and 1,000 nm. More preferably, the film thickness is between 20 nm and 200 nm. The film 32 can be made of a material including at least one of polymer, polyethylene, polyimide, polypropylene, carbon, silicon oxide, silicon nitride, and boron nitride.

The primary beam 7 can be an electron beam or an ion beam. On the specimen-holding surface, cells or biological tissues can be cultured.

A specimen inspection apparatus of the present invention is used to observe or inspect a specimen using the above-described specimen holder 40. The specimen inspection apparatus has the holder support 12 on which the specimen holder 40 is placed, the primary beam irradiation means 1 for irradiating the specimen 38 placed on the specimen-holding surface 32a of the film 32 of the specimen holder 40 with the primary beam 7 via the film 32, and the signal detectionmeans 4 for detecting a secondary signal produced from the specimen 38 in response to the irradiation by the primary beam 7.

The specimen inspection apparatus further includes the vacuum chamber 11 installed in the specimen inspection apparatus to make the ambient in contact with the second surface 32b of the film 32 of the specimen holder 40 a vacuum ambient, the second surface 32b facing away from the first surface 32a.

The primary beam 7 is an electron beam or an ion beam. The secondary signal can be any one type of secondary electrons, backscattered electrons, absorption current, cathodoluminescent light, and X-rays. The first surface 32a of the film 32 of the specimen holder 40 is the upper surface of the film 32. The second surface 32b facing away from the first surface is the lower surface of the film 32.

A specimen inspection method of the present invention consists of culturing the specimen 38 on the specimen-holding surface of the specimen holder 40, irradiating the cultured specimen 38 with the primary beam 7 via the film 32, and detecting a secondary signal emanating from the specimen 38 in response to the irradiation by the beam 7.

During the irradiation by the primary beam 7, the second surface 32b of the film 32 of the specimen holder 40 that faces away from the first surface 32a of the film 32 is in contact with a vacuum ambient. The primary beam 7 is directed at the specimen through the vacuum ambient.

## Claims

1. A specimen holder comprising:
a body portion having a specimen-holding surface and a film, the specimen-holding surface being opened to permit access from the outside, the film having a first surface constituting the specimen-holding surface; and
an electrically conductive region and an optically transparent region formed on a surface of the body portion on an opposite side of the specimen-holding surface;
wherein a primary beam for observation or inspection of the specimen can be directed via the film at a specimen disposed on the first surface of the film.

2. A specimen holder as set forth in claim 1, wherein said electrically conductive region is formed by coating with an electrically conductive film.

3. A specimen holder as set forth in claim 2, wherein said optically transparent region is not covered with said electrically conductive film.

4. A specimen holder as set forth in any one of claims 1 to 3, wherein a hole is formed in a part of said specimen-holding surface of the body portion, and wherein said film is disposed to cover the hole.

5. A specimen holder as set forth in claim 4, wherein said film is formed on a framelike member having an opening such that the opening is covered with the film, and wherein the framelike member is disposed in a corresponding manner to the hole in the body portion.

6. A specimen holder as set forth in claim 5, wherein said framelike member is disposed on a step portion formed over or along the hole in the body portion.

7. A specimen holder as set forth in any one of claims 1 to 6, wherein said electrically conductive region or said electrically conductive film has a resistivity of less than 10⁴ Ω · m.

8. A specimen holder as set forth in any one of claims 1 to 7, wherein said electrically conductive region or said electrically conductive film is made of at least one of gold, silver, aluminum, indium tin oxide, zinc oxide and tin oxide, and wherein said body portion is made of at least one of plastic, glass, indium tin oxide, zinc oxide and tin oxide.

9. A specimen holder as set forth in any one of claims 1 to 8, wherein said film includes at least one of polymer, polyethylene, polyimide, polypropylene, carbon, silicon oxide, silicon nitride and boron nitride, and wherein said film has a thickness of 10 to 1,000 nm.

10. A specimen inspection apparatus for observing or inspecting a specimen using a specimen holder as set forth in any one of claims 1 to 9, said specimen inspection apparatus comprising:
a holder support on which the specimen holder is placed;
primary beam irradiation means for irradiating the specimen disposed on the specimen-holding surface of the film of the specimen holder with a primary beam via the film; and
signal detection means for detecting a secondary signal emanating from the specimen in response to the irradiation by the primary beam.

11. A specimen inspection apparatus as set forth in claim 10, wherein said film of the specimen holder has a second surface facing away from the first surface, and wherein there is further provided a vacuum chamber for making an ambient in contact with the second surface a vacuum ambient, and wherein an electron beam or ion beam passes the vacuum chamber and reaches the specimen via the film as said primary beam, and wherein said secondary signal is any one type of secondary electrons, backscattered electrons, absorption current, cathodoluminescent light, and X-rays.

12. A specimen inspection apparatus as set forth in any one of claims 10 and 11, wherein the first surface of said film of the specimen holder is an upper surface of the film, and a second surface of the film facing away from the first surface is a lower surface of the film.

13. A method of inspecting a specimen, comprising the steps of:
preparing a specimen holder as set forth in any one of claims 1 to 9;
culturing the specimen on the specimen-holding surface of the specimen holder;
irradiating the cultured specimen with a primary beam via the film; and
detecting a secondary signal emanating from the specimen in response to the irradiation by the primary beam.

14. A method of inspecting a specimen as set forth in claim 13, wherein during the irradiation by the primary beam, a second surface of the film of the specimen holder facing away from the first surface is in contact with a vacuum ambient through which the primary beam is directed at the specimen.

15. A method of inspecting a specimen as set forth in any one of claims 13 and 14, wherein said primary beam is an electron beam or an ion beam, and wherein said secondary signal is any one type of secondary electrons, backscattered electrons, absorption current, cathodoluminescent light, and X-rays.
